# EUROPEAN PATENT APPLICATION

(11) **EP 4 773 168 A1**
(43) Date of publication of application: **08.07.2026**
(21) Application number: 24899837.9
(22) Date of filing: 04.12.2024
(51) Int. Cl.: H01L 21/033, H01L 21/266

(54) **MANUFACTURING METHOD FOR SEMICONDUCTOR DEVICE**

(30) Priority: 07.12.2023 CN 202311676668
(71) Applicant: United Nova Technology - Yuezhou (Shaoxing) Corp., Shaoxing, Zhejiang 312000 (CN)
(72) Inventor: LI, Xiang, Shaoxing, Zhejiang 312000 (CN); ZHOU, Weiping, Shaoxing, Zhejiang 312000 (CN); HE, Qiong, Shaoxing, Zhejiang 312000 (CN); ZHANG, Yukai, Shaoxing, Zhejiang 312000 (CN); HE, Yun, Shaoxing, Zhejiang 312000 (CN)
(74) Representative: Kraus & Lederer PartGmbB
(86) International application number: PCT/CN2024/136619
(87) International publication number: WO 2025/119199

(57) **Abstract**

The present invention provides a method for manufacturing a semiconductor device. A first carbon film is formed on a semiconductor substrate to serve as a mask layer, and a patterned photoresist layer is formed on the first carbon film by adopting a silicon-containing photoresist material. Moreover, after the first carbon film is etched with the patterned photoresist layer as a mask to transfer a corresponding pattern onto the first carbon film, the photoresist layer is carbonized to be converted into a second carbon film. On the one hand, this can avoid the problem that a photoresist-bearing film layer contaminates processing tools when entering a subsequent high-temperature processing process, and the problem that the morphology of a photoresist changes under the subsequent high-temperature processing process, which is detrimental to pattern transfer into the semiconductor substrate. On the other hand, after completion of a subsequent semiconductor processing process, the second carbon film and the first carbon film can also be removed through the same removal process, thereby simplifying the process, reducing costs, and avoiding photoresist residues.

## Description

### TECHNICAL FIELD

The present invention relates to the technical field of semiconductor device manufacturing, and in particular, to a method for manufacturing a semiconductor device.

### BACKGROUND

A patterning process is a common process or technique in the manufacturing process of semiconductor devices. Generally, a mask layer is formed on a semiconductor substrate, and a layer of light-sensitive material, such as a patterned photoresist layer, is coated on the mask layer. Then, a patterned reticle (mask) is used to expose the semiconductor substrate to radiation for exposure and development, so as to transfer the pattern on the patterned reticle onto the photoresist layer. Thereafter, the mask layer is etched with the photoresist as a mask, and then the pattern in the photoresist layer is transferred onto the mask layer.

The above patterning process has the following defects:
1. At present, expensive deposition equipment is commonly used to deposit one or more composite film layers, such as monocrystalline silicon, amorphous silicon, silicon oxide, silicon nitride, silicon oxynitride, a metal, and a metal nitride, as the mask layers. The film layer deposition process features a long deposition time, low production efficiency, and high costs. In addition, expensive etching equipment is required to etch the mask layer with the photoresist as the mask, which further increases the manufacturing costs.
2. In the manufacturing process of some semiconductor devices, high-temperature processing processes such as high-temperature ion implantation are frequently used. On the one hand, a photoresist-bearing film layer contaminates these processing tools when entering these high-temperature processing processes. On the other hand, the photoresist becomes deformed and its morphology changes under these high-temperature processing processes, which is detrimental to the downward transfer of the pattern.
3. The above photoresist layer and mask layer need to be removed through different processes, resulting in complex processes and high costs.

### SUMMARY

An objective of the present invention is to provide a method for manufacturing a semiconductor device, which can simplify the process and reduce costs.

To achieve the above objective, the present invention provides a method for manufacturing a semiconductor device, including:
providing a semiconductor substrate, and forming a first carbon film serving as a mask layer on the semiconductor substrate;
forming a patterned photoresist layer on the first carbon film by adopting a silicon-containing photoresist material;
etching the first carbon film with the photoresist layer as a mask to pattern the first carbon film;
carbonizing the photoresist layer to convert the photoresist layer into a second carbon film; and
processing the semiconductor substrate with the first carbon film and the second carbon film as masks to form a desired pattern in the semiconductor substrate.

Optionally, the first carbon film is formed by at least one process of coating, physical vapor deposition, chemical vapor deposition, atomic layer deposition, and epitaxial growth.

Optionally, a material of the first carbon film includes amorphous carbon.

Optionally, the first carbon film is etched by adopting an oxygen element-dominated dry etching process with the photoresist layer as a mask to pattern the first carbon film.

Optionally, the photoresist layer is subjected to a baking treatment to remove moisture within the photoresist layer, so that carbon elements in the photoresist layer are deposited on the first carbon film to form the second carbon film.

Optionally, a temperature of the baking treatment is 300°C-1500°C.

Optionally, a step of the processing the semiconductor substrate with the first carbon film and the second carbon film as masks includes: performing ion implantation on the semiconductor substrate with the first carbon film and the second carbon film as the masks to form an ion implantation region with the desired pattern in the semiconductor substrate.

Optionally, the semiconductor substrate is a silicon carbide epitaxial wafer, and the ion implantation region is a well region, a source region, or a body contact region of a silicon carbide transistor.

Optionally, after the processing the semiconductor substrate with the first carbon film and the second carbon film as masks, the method further includes: removing the second carbon film and the first carbon film through the same removal process.

Optionally, after the performing ion implantation on the semiconductor substrate, and before or after the removing the second carbon film and the first carbon film, the method further includes: performing annealing to activate implanted ions in the ion implantation region.

Compared with the prior art, in the technical solutions of the present invention, a first carbon film is formed on a semiconductor substrate serve as a mask layer, and a patterned photoresist layer is formed on the first carbon film by adopting a silicon-containing photoresist material. Moreover, after the first carbon film is etched with the photoresist layer as a mask to transfer a corresponding pattern onto the first carbon film, the photoresist layer is carbonized to be converted into a second carbon film. On the one hand, this can avoid the problem that a photoresist-bearing film layer contaminates processing tools when entering a subsequent high-temperature processing process, and the problem that the morphology of a photoresist changes under the subsequent high-temperature processing process, which is detrimental to pattern transfer into the semiconductor substrate. On the other hand, after completion of a subsequent semiconductor processing process, the second carbon film and the first carbon film can also be removed through the same removal process, thereby simplifying the process, reducing costs, and avoiding photoresist residues.

### BRIEF DESCRIPTION OF THE DRAWINGS

Those of ordinary skill in the art will understand that the drawings are provided for a better understanding of the present invention and do not constitute any limitation on the scope of the present invention. In the drawings:
FIG. 1 is a schematic flow diagram of a method for manufacturing a semiconductor device according to an embodiment of the present invention.
FIG. 2 is a schematic cross-sectional diagram of a device in a method for manufacturing a semiconductor device according to an embodiment of the present invention.

### DETAILED DESCRIPTION

In the following description, numerous specific details are set forth in order to provide a thorough understanding of the present invention. However, it will be apparent to those skilled in the art that the present invention may be implemented without one or more of these details. In other examples, to avoid confusion with the present invention, some technical features well known in the art have not been described. It should be understood that the present invention can be implemented in different forms and should not be construed as limited to the embodiments set forth herein. On the contrary, these embodiments are provided so that the disclosure will be thorough and complete, and will fully convey the scope of the present invention to those skilled in the art. Like reference numerals refer to like elements throughout. It should be understood that when an element is referred to as being "connected to" or "coupled to" another element, the element may be directly connected to the other element, or an intervening element may exist. In contrast, when an element is referred to as being "directly connected to" another element, there are no intervening elements. As used herein, the singular forms "a," "an," and "the" are intended to include the plural forms as well, unless the context clearly indicates otherwise. It should also be understood that the term "include" is used to determine existence of features, steps, operations, elements, and/or components, but does not exclude existence or addition of one or more other features, steps, operations, elements, components, and/or groups. As used herein, the term "and/or" includes any and all combinations of related listed items.

The technical solutions proposed by the present invention will be further described in detail below in conjunction with the drawings and specific embodiments. The advantages and features of the present invention will become clearer from the following description. It should be noted that the drawings are provided in a very simplified form and are not drawn to precise scale, and are merely used for the purpose of conveniently and clearly assisting in illustrating the embodiments of the present invention.

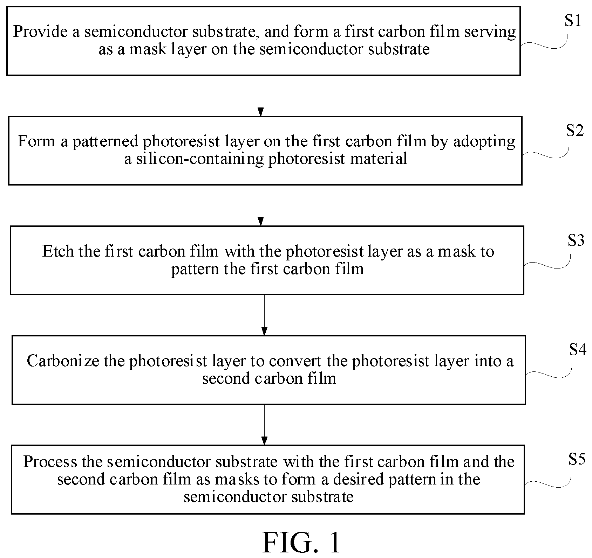

Referring to FIG. 1, an embodiment of the present invention provides a method for manufacturing a semiconductor device, including:
S1. providing a semiconductor substrate, and forming a first carbon film serving as a mask layer on the semiconductor substrate;
S2. forming a patterned photoresist layer on the first carbon film by adopting a silicon-containing photoresist material;
S3. etching the first carbon film with the photoresist layer as a mask to pattern the first carbon film;
S4. carbonizing the photoresist layer to convert the photoresist layer into a second carbon film; and
S5. processing the semiconductor substrate with the first carbon film and the second carbon film as masks to form a desired pattern in the semiconductor substrate.

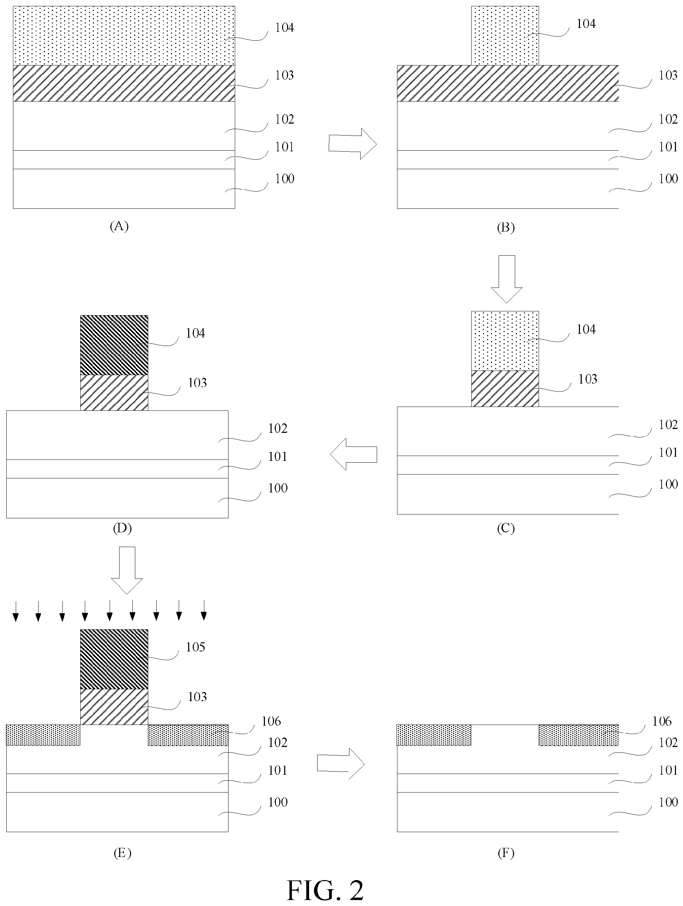

Referring to (A) in FIG. 2, in step S1, a semiconductor substrate is provided, and a first carbon film 103 serving as a mask layer is formed on the semiconductor substrate through at least one of any suitable processes such as coating, physical vapor deposition (PVD), chemical vapor deposition (CVD), atomic layer deposition (ALD), and epitaxial growth.

Optionally, before the first carbon film 103 is formed, an oxide layer (not shown) is formed on a surface of an SiC drift layer 102 through any suitable process such as thermal oxidation or atomic layer deposition or chemical vapor deposition. The oxide layer may serve as a protective layer, an etch stop layer, or the like for a subsequent processing process.

An intrinsic material of the provided semiconductor substrate may include, but is not limited to, at least one of any suitable semiconductor materials such as silicon (Si), germanium (Ge), silicon carbide (SiC), silicon germanium (SiGe), gallium nitride (GaN), and gallium arsenide (GaAs). The semiconductor substrate may be a bulk single crystal material (e.g., bulk silicon), a semiconductor-on-insulator material (e.g., silicon-on-insulator), or an epitaxial wafer (e.g., a silicon carbide film layer epitaxially grown on a silicon substrate), etc. As an example, the semiconductor substrate is a silicon carbide epitaxial wafer, which may include a substrate 100 (which may be Si or SiC), an SiC buffer layer 101, and an SiC drift layer 102 stacked in sequence from bottom to top. The substrate 100, the SiC buffer layer 101, and the SiC drift layer 102 may all be n-type, and doping concentrations of n-type impurities in the substrate 100, the SiC buffer layer 101, and the SiC drift layer 102 decrease in sequence.

A main material of the formed first carbon film 103 is carbon. For example, its material may include amorphous carbon (also known as non-crystalline carbon). As an example, in step S1, the first carbon film 103 is formed on the SiC drift layer 102 through a magnetron sputtering process (i.e., a type of PVD).

In step S2, first, referring to (A) in FIG. 2, a photoresist containing silicon and carbon elements (i.e., an organic light-sensitive material containing silicon and carbon elements, which may also be referred to as a silicon-containing photoresist material) is coated on the first carbon film 103 to form a photoresist layer 104. The photoresist layer 104 may be exposed, developed, and carbonized, and its specific material selected may be any suitable silicon-containing photoresist material in the art, which is not specifically limited in the present invention.

In step S2, next, referring to (B) in FIG. 2, the photoresist layer 104 is exposed and developed, thereby forming a patterned photoresist layer 104, that is, forming a pattern required for device manufacturing in the photoresist layer 104.

In step S3, peferring to (C) in FIG. 2, with the patterned photoresist layer 104 as a mask, the first carbon film 103 is etched by adopting an oxygen element-dominated dry etching process (e.g., an oxygen plasma etching process), and the etching stops on the surface of the SiC drift layer 102 or on the oxide layer on the surface of the SiC drift layer 102, thereby patterning the first carbon film 103, that is, removing the first carbon film 103 exposed by the patterned photoresist layer 104, so as to transfer a pattern in the photoresist layer 104 into the first carbon film 103.

In step S4, referring to (D) in FIG. 2, the patterned photoresist layer 104 is carbonized by adopting any suitable process, thereby converting the patterned photoresist layer 104 into a second carbon film 105.

As an example, the semiconductor substrate with the patterned first carbon film 103 is placed in a baking furnace for baking treatment under atmospheric pressure or low pressure, and the baking temperature is, for example, 300°C to 1500°C. The presence of an oxygen atmosphere is avoided during carbonization to prevent the photoresist from being oxidized and burned. The baking atmosphere is, for example, an inert gas such as argon or an atmosphere such as nitrogen that does not react with the photoresist and the like, so that the organic matter in the photoresist layer 104 is rapidly volatilized and decomposed, a product maybe quickly discharged, and excess moisture is removed, thereby leaving a carbon element-dominated material deposited on the first carbon film 103 to form the second carbon film 105, and reducing impurity components in the formed second carbon film 105 at the same time. This process does not cause a pattern in each film layer to deform beyond a requirement, so that the pattern is completely retained, that is, a pattern in the second carbon film 105 remains consistent with that in the patterned photoresist layer 104.

In step S5, referring to (E) in FIG. 2, the semiconductor substrate is processed (e.g., by a processing process at a temperature not lower than 500°C) with the second carbon film 105 and the first carbon film 103 as masks to form a desired pattern in the semiconductor substrate. Since the photoresist layer has been carbonized into the second carbon film 105 capable of withstanding a high temperature and is not easily deformed in a high-temperature environment, after the semiconductor substrate with the second carbon film 105 and the first carbon film 103 is sent to a high-temperature processing tool, the pattern and morphology of the second carbon film 105 are not deformed, facilitating transfer of a corresponding pattern into the semiconductor substrate, and the problem of photoresist contamination of the high-temperature processing tool is avoided.

As an example, high-temperature ion implantation (with an implantation temperature not lower than 500°C) is performed on the SiC drift layer 102 of the semiconductor substrate with the second carbon film 105 and the first carbon film 103 as masks, so as to form an ion implantation region 106 with a desired pattern in the SiC drift layer 102. The obtained ion implantation region has a good morphology, and the problem of photoresist contamination of the high-temperature processing tool does not exist during the high-temperature ion implantation.

After step S5, when the second carbon film 105 and the first carbon film 103 need to be removed, referring to (F) in FIG. 2, since material properties of the second carbon film 105 and the first carbon film 103 are similar (e.g., both are carbon element-dominated materials), the second carbon film 105 and the first carbon film 103 may be removed by the same removal process.

As an example, an oxygen (O) element-dominated removal method (e.g., a dry photoresist stripping process in an oxygen atmosphere or an oxygen plasma etching process) is adopted to simultaneously remove the second carbon film 105 and the first carbon film 103 in the same removal process, which can simplify the process and reduce costs, and does not generate photoresist residues.

Optionally, in an embodiment of the present invention, after removing the second carbon film 105 and the first carbon film 103, a carbon film (not shown) may be re-formed as a protective layer, thereby performing annealing to activate implanted ions under protection of a new carbon film. The newly formed carbon film can protect a surface of the semiconductor substrate and prevent it from suffering high-temperature damage in a process of annealing for activation.

Optionally, in another embodiment of the present invention, after performing ion implantation on the semiconductor substrate, and before removing the second carbon film and the first carbon film, the method further includes: performing annealing to activate implanted ions in the ion implantation region 106.

To better illustrate the technical effects of the present invention, manufacture of an SiC transistor is taken as an example below to compare the prior art with the solution of the present invention.

Referring to FIG. 2, multiple ion implantation processes are generally needed for the SiC drift layer 102 to form ion implantation regions such as a well region (not shown), a source region (not shown), a JTE region (not shown), and a body contact region (not shown) of the SiC transistor.

First, in the prior art, any ion implantation process for forming ion implantation regions such as the well region, the source region, the JTE region, and the body contact region of the SiC transistor includes the following steps: depositing silicon oxide and silicon nitride on the SiC drift layer 102 as a mask layer, and coating a photoresist on the mask layer; after performing exposure and development, etching the mask layer with the photoresist as a mask, and then directly performing corresponding high-temperature ion implantation with the photoresist and the mask layer as masks to form a corresponding ion implantation region; and after the ion implantation process is completed, first removing the photoresist and then removing the mask layer. Deposition costs of the mask layer are high, a high-temperature ion implantation process causes the problem of photoresist contamination of the processing tool, and the problem of photoresist deformation at a high temperature, which is detrimental to pattern transfer, and the photoresist and the mask layer need to be sequentially removed through different removal processes.

When any ion implantation process for forming ion implantation regions such as the well region, the source region, the JTE region, and the body contact region of the SiC transistor is replaced with the technical solution of the present invention, referring to FIG. 2, the process includes the following steps: first, depositing a first carbon film on the SiC drift layer 102 as a mask layer to replace deposition of film layers such as silicon nitride in the prior art, thereby shortening a process time and reducing costs; second, forming a patterned photoresist layer 104 on the first carbon film 103 by adopting a silicon-containing photoresist material, and further etching the first carbon film 103 with the patterned photoresist layer 104 as a mask; next, carbonizing the photoresist layer 104 into a second carbon film 105 first, and then performing corresponding high-temperature ion implantation with the second carbon film 105 and the first carbon film 103 as masks to form a corresponding ion implantation region 106, where deposition costs of the first carbon film 103 are high, and the photoresist layer 104 is carbonized into the second carbon film 105 first, so the problem of photoresist contamination of the processing tool, and the problem of photoresist deformation at a high temperature which is detrimental to pattern transfer will not occur during the high-temperature ion implantation process; and afterwards, removing the second carbon film and the first carbon film through the same removal process. This solution is simple, efficient, and low-cost, and is suitable for large-scale production.

In summary, in the technical solutions of the present invention, a first carbon film is formed on a semiconductor substrate serve as a mask layer, and a patterned photoresist layer is formed on the first carbon film by adopting a silicon-containing photoresist material. Moreover, after the first carbon film is etched with the patterned photoresist layer as a mask to transfer a corresponding pattern onto the first carbon film, the patterned photoresist layer is carbonized to be converted into a second carbon film. On the one hand, this can avoid the problem that a photoresist-bearing film layer contaminates processing tools when entering a subsequent high-temperature processing process, and the problem that the morphology of a photoresist changes under the subsequent high-temperature processing process, which is detrimental to pattern transfer into the semiconductor substrate. On the other hand, after completion of a subsequent semiconductor processing process, the second carbon film and the first carbon film can also be removed through the same removal process, thereby simplifying the process, reducing costs, and avoiding photoresist residues. The technical solutions of the present invention are applicable to manufacture of any suitable semiconductor device.

The foregoing description is merely one of the preferred embodiments of the present invention and does not constitute any limitation on the scope of the present invention. Any alteration and modification made by those of ordinary skill in the art of the present invention based on the above disclosure shall fall within the scope of protection of the technical solutions of the present invention.

## Claims

1. A manufacturing method for a semiconductor device, comprising:
providing a semiconductor substrate, and forming a first carbon film serving as a mask layer on the semiconductor substrate;
forming a patterned photoresist layer on the first carbon film by adopting a silicon-containing photoresist material;
etching the first carbon film with the photoresist layer as a mask to pattern the first carbon film;
carbonizing the photoresist layer to convert the photoresist layer into a second carbon film; and
processing the semiconductor substrate with the first carbon film and the second carbon film as masks to form a desired pattern in the semiconductor substrate.

2. The manufacturing method according to claim 1, wherein the first carbon film is formed by at least one process of coating, physical vapor deposition, chemical vapor deposition, atomic layer deposition, and epitaxial growth.

3. The manufacturing method according to claim 1, wherein a material of the first carbon film comprises amorphous carbon.

4. The manufacturing method according to claim 1, wherein the first carbon film is etched by adopting an oxygen element-dominated dry etching process with the photoresist layer as a mask to pattern the first carbon film.

5. The manufacturing method according to claim 1, wherein the photoresist layer is subjected to a baking treatment, so that moisture within the photoresist layer is dried, causing carbon elements in the photoresist layer are deposited on the first carbon film, thereby forming the second carbon film.

6. The manufacturing method according to claim 5, wherein a temperature of the baking treatment is 300°C-1500°C.

7. The manufacturing method according to any one of claims 1-6, wherein a step of the processing the semiconductor substrate with the first carbon film and the second carbon film as masks comprises: performing ion implantation on the semiconductor substrate with the first carbon film and the second carbon film as the masks to form an ion implantation region with the desired pattern in the semiconductor substrate.

8. The manufacturing method according to claim 7, wherein the semiconductor substrate is a silicon carbide epitaxial wafer, and the ion implantation region is a well region, a source region, or a body contact region of a silicon carbide transistor.

9. The manufacturing method according to any one of claims 1-6 or 8, wherein after the processing the semiconductor substrate with the first carbon film and the second carbon film as masks, the method further comprises: removing the second carbon film and the first carbon film through the same removal process.

10. The manufacturing method according to claim 7, wherein after the performing ion implantation on the semiconductor substrate, and before or after the removing the second carbon film and the first carbon film, the method further comprises: performing annealing to activate implanted ions in the ion implantation region.

11. The manufacturing method according to claim 1, wherein the carbonizing the photoresist layer to convert the photoresist layer into a second carbon film comprises: carbonizing the photoresist layer to volatilize and decompose organic matter within the photoresist layer, leaving a carbon element-dominated material, so that the photoresist layer is entirely converted into the second carbon film capable of withstanding a high temperature of not lower than 500°C and not easily deformed in a high-temperature environment.

12. The manufacturing method according to claim 1, wherein the semiconductor substrate is processed by adopting a high-temperature processing process with a temperature of not lower than 500°C.

13. The manufacturing method according to claim 9, wherein the second carbon film and the first carbon film are removed simultaneously in the same removal process by adopting a dry photoresist stripping process or an oxygen plasma etching process in an oxygen atmosphere.

14. The manufacturing method according to claim 9, wherein after the removing the second carbon film and the first carbon film, the method further comprises: re-forming a carbon film as a protective layer, thereby performing annealing to activate the implanted ions under protection of the newly formed carbon film.
